# EUROPEAN PATENT APPLICATION

(11) **EP 1 387 600 A1**
(43) Date of publication of application: **04.02.2004**
(21) Application number: 02016924.9
(22) Date of filing: 31.07.2002
(51) Int. Cl.: H04R 25/00, H03G 5/16, H03G 9/02, G10L 21/02

(54) **Sound processing apparatus and hearing aid**

(71) Applicant: Shoei Co., Ltd., Tokyo 101-0054 (JP); Canon Electronics Inc., Chichibu-shi, Saitama 369-1892 (JP)
(72) Inventor: Negishi, Ryuichi, Canon Electronics Inc., Saitama 369-1892 (JP)
(74) Representative: Grünecker, Kinkeldey, Stockmair & Schwanhäusser Anwaltssozietät

(57) **Abstract**

The present invention provides a sound processing apparatus capable of outputting clearly preceivable sound. The sound processing apparatus comprises high frequency range enhancement unit (4) for a sound signal amplified by an amplifier (1), gain-varying unit (5) for varying the gain of a sound signal whose high frequency component is enhanced on the basis of a control signal presented from amplitude sensing unit (8), addition unit (2) for adding a sound signal that is output from the gain-varying unit and a sound signal from the amplifier, frequency characteristic adding unit (7) whereby the amplitude of the sound signal that is input from the amplifier is increased with increasing frequency in the specified frequency range, and amplitude sensing unit (8) for sensing the magnitude of the amplitude of the sound signal from frequency characteristic adding unit (7) and generating a voltage signal as a control signal substantially proportional to the amplitude thereof.

## Description

### BACKGROUND OF THE INVENTION

### Field of the Invention

The present invention relates to sound signal processing means used in hearing aids, and to a hearing aid.

### Related Background Art

In conventional practice, hearing aids used to compensate for hearing deficiency are configured such that amplification can be performed in order to enhance high frequency sound signals. According to another structure, automatic gain control (AGC) is carried out to follow variations in sound level.

Also, Japanese Patent Application Laid-Open No. 2000-20098 discloses a technique in which basic frequency components are extracted from a speech signal, and frequency components that are integral multiples of the basic frequency components are enhanced.

When, however, a user receives sound information through such a conventional hearing aid, for example, the high-frequency components of the sound information are overemphasized and are perceived as high-pitched sound, creating a feeling of discomfort when the volume is increased. In addition, the sound image wobbles when AGC is performed. Complicated processing circuitry is also required.

### SUMMARY OF THE INVENTION

It is an object of the present invention to provide a sound processing apparatus and hearing aid that are capable of outputting clearly perceivable sound.

It is further object of the invention to provide a sound processing apparatus comprises processing means having at least high frequency range enhancement processing means and gain-varying means for a sound signal input; addition means for adding the input sound signal and a sound signal obtained through the processing means; and sound signal analysis means for analyzing the input sound signal and generating a control signal for the gain-varyingmeans on the basis of the analysis results.

It is another object of the invention to provide a hearing aid comprising processingmeans having at least high frequency range enhancement processing means and gain-varying means for a input sound signal; addition means for adding the input sound signal and the sound signal obtained through the processing means; and sound signal analysis means for analyzing the input sound signal and generating a control signal for the gain-varying means on the basis of the analysis results.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicatingpreferred embodiments of the invention, are given by way of illustration only, since various changes and modifications within the spirit and scope of the invention will become apparent to those skilled in the art from this detailed description.

### BRIEF DESCRIPTION OF THE DRAWINGS

Fig. 1 is a block diagram depicting the structure of the sound processing apparatus according to a first embodiment of the present invention;
Fig. 2 is a diagram depicting an example of the sound signal gain characteristics in the sound processing apparatus depicted in Fig. 1;
Fig. 3 is a block diagram depicting the structure of the sound processing apparatus according to a second embodiment of the present invention;
Fig. 4 is a block diagram depicting the structure of the sound processing apparatus according to a third embodiment of the present invention; and
Fig. 5 is a block diagram depicting the structure of the sound processing apparatus according to a fourth embodiment of the present invention.

### DESCRIPTION OF THE PREFERRED EMBODIMENTS

Embodiments of the present invention will be described below with reference to the figures.

### First Embodiment

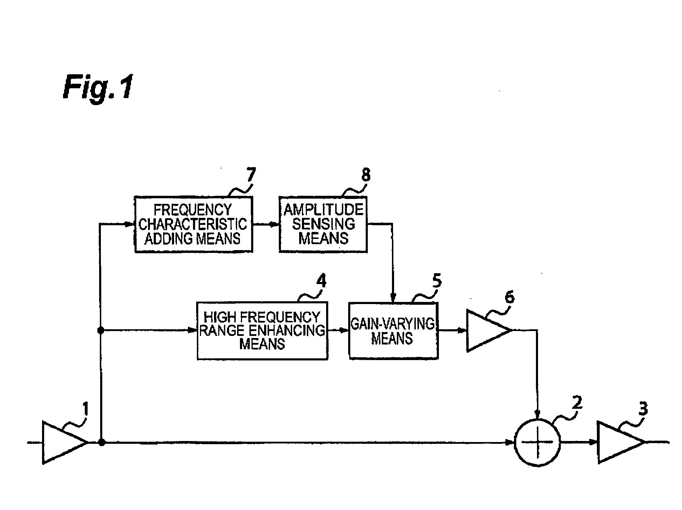

Fig. 1 is a block diagram depicting the structure of the sound processing apparatus according to a first embodiment of the present invention.

The sound processing apparatus comprises an amplifier 1 for inputting a sound signal, and the amplifier 1 amplifies the input sound signal in the audio bandwidth, as shown in Fig. 1. The sound signal amplified by the amplifier 1 is input to high frequency range enhancement means 4, and the high frequency range enhancement means 4 enhances the high-frequency component of the input sound signal. The sound signal with the enhanced high-frequency component is input to gain-varying means 5, and the gain-varying means 5 varies the gain of the input sound signal on the basis of a control signal provided from the amplitude sensing means 8 described below, and outputs the sound signal. The gain-varying means 5 acts to decrease the sound signal gain as the control signal voltage increases. The sound signal that is output from the gain-varying means 5 is amplified by an amplifier 6 and is input to addition means 2. The addition means 2 adds the sound signal from the amplifier 6 and the sound signal from the amplifier 1, and the added sound signals are output after being amplified by an amplifier 3.

Frequency characteristic adding means 7 increases the amplitude of the input sound signal from the amplifier 1 as the frequency thereof increases within the specified frequency range. The sound signal processed by the frequency characteristic adding means 7 is input to the amplitude sensing means 8, which, together with the frequency characteristic adding means 7, constitutes sound signal analysis means. The amplitude sensing means 8 senses the magnitude of amplitude of the input sound signal and generates, as a control signal, a voltage signal substantially proportional to the amplitude magnitude. The control signal is input to the gain-varying means 5, and the gain-varying means 5 varies the gain of the input sound signal on the basis of the control signal voltage.

Next, the operation of this embodiment will be described.

After being input to the amplifier 1 and amplified by the amplifier 1, the sound signal is input to the addition means 2 via the high frequency range enhancement means 4, the gain-varying means 5, and the amplifier 6. The sound signal that is input through the high frequency range enhancement means 4, the gain-varying means 5 and the amplifier 6, and the sound signal that is output from the amplifier 1 are then added together in the addition means 2, and the added sound signals are output after being amplified by the amplifier 3.

The sound signal amplified by the amplifier 1 is input to the frequency characteristic addingmeans 7. The frequency characteristic adding means 7 increases the amplitude of the input sound signal as the frequency thereof increases within the specified frequency range. The sound signal from the amplifier 1 is input to the amplitude sensing means 8 after the high frequency amplitude thereof is thus enhanced. The amplitude sensing means 8 senses the magnitude of amplitude of the input sound signal and generates, as a control signal, a voltage signal substantiallyproportional to the amplitude magnitude. The control signal is presented to the gain-varying means 5, and the gain-varying means 5 varies the gain of the input sound signal on the basis of the control signal voltage. Since the amplitude of the sound signal is increasedwith increased frequencyby the frequency characteristic adding means 7, the sound signal output of the amplitude sensing means 8 acquires higher voltage with increasing frequency, and the gain-varying means 5 decreases the sound signal gain as the control signal voltage increases.

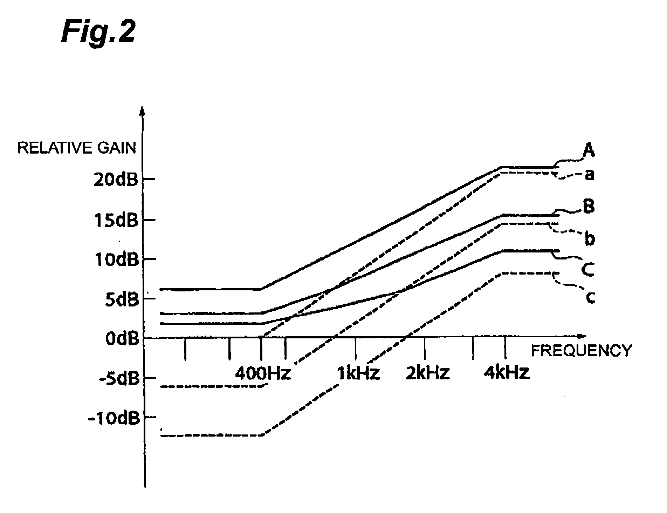

Next, the sound signal gain characteristics of this embodiment will be described with reference to Fig. 2. Fig. 2 is a diagram depicting an example of the sound signal gain characteristics of the sound processing apparatus shown in Fig. 1.

In Fig. 2, the curves *a, b,* and *c* shown by the broken lines represent examples of the sound signal gain characteristics between the input terminal of the high frequency range enhancement means 4 and the output terminal of the amplifier 6 through the gain-varying means 5. Characteristic curve *a* corresponds to the characteristic obtained when the gain-varying means 5 has the maximum gain. The gain rises from about 400 Hz and returns to a flat characteristic at about 4 kHz. The curves b and c represent characteristics in which the gain of the gain-varying means 5 is below the maximum level by 6 dB and 12 dB, respectively.

If the output from the amplifier 1 is taken as a reference (0 dB), then the input to the addition means 2 will comprise a signal with flat 0-dB frequency characteristics and a signal with the enhanced high frequency range presented by curve *a*, *b*, *c*, or the like, and the output of the addition means 2 will be presented by a solid-line characteristic curve A for the input of the characteristic curve *a*, a solid-line characteristic curve B for the input of the characteristic curve *b*, and a solid-line characteristic curve C for the input of the characteristic curve *c*.

The output amplitude increases with an increase in the frequency of the main component of the sound signal, and a control signal with a rather low voltage is provided from the amplitude sensing means 8 to the gain-varying means 5 for a sound signal whose main component has a low frequency if it is assumed, for example, that the characteristics of the frequency characteristic adding means 7 are such that the gain increases with increasing frequency increases between 100 Hz and several kilohertz. The gain-varyingmeans 5 will operate to increase the gain of the sound signal when a control signal with a low voltage is provided. As a result, a characteristic close to the one expressed by the characteristic curve A in Fig. 2 will be obtained as the overall frequency characteristic. In this case, the gain is only 6 dB in the vicinity of 300 Hz, but 19 dB in the vicinity of 3 kHz, ensuring sufficiently clear reception.

For a sound signal whose main component has an intermediate frequency, a control signal with an intermediate voltage is applied to the gain-varying means 5. The gain of the gain-varying means 5 is also intermediate, so the overall frequency characteristic is close to the characteristic expressed by the characteristic curve B in Fig. 2. In this case, the gain is only 5 dB in the vicinity of 600 Hz, but 13 dB in the vicinity of 3 kHz, ensuring sufficiently clear reception.

For the highest-pitched sound (for which the frequency of the main component lies in the vicinity of 1 kHz) , acontrol signal with an increased voltage is provided to the gain-varying means 5, and the gain of the control signal decreases, so the overall frequency characteristic is close to the characteristic presented by the characteristic curve C in Fig. 2, the overall frequency characteristic becomes low. In this case, the gain is only 4 dB in the vicinity of 1 kHz, but 9 dB in the vicinity of 3 kHz, resulting in higher hearing clarity.

Sound can thus be perceived clearly and without any high-pitched sounds or a sense of discomfort because the gain at higher frequencies can be allowed to vary over a wider range without creating significant variations in the gain achieved near the frequency of the main component of the sound signal. In addition, the reduction in the gain variations occurring at the frequency of the main component of a sound signal acts to prevent the sound image wobbling typical of AGC.

By using the sound processing apparatus according to this embodiment, it is possible to provide a hearing aid capable of producing a clearly perceptible sound.

Although the present embodiment was described with reference to a case in which the characteristics of the frequency characteristic adding means 7 were such that the gain increased with increasing frequency, it is also possible to adopt an arrangement in which the characteristics of the frequency characteristic adding means 7 are such that a frequency range of several kilohertz (for example, 3 kHz) or greater is reduced and, at the same time, the gain in another frequency range (for example, between about 100 Hz and several kilohertz) is increased with increasing frequency in the same manner as above. In this case, the gain of the gain-varying means 5 does not decrease too much because both the amplitude of the signal entered into the amplitude sensing means 8 and the voltage of the control signal generated by the amplitude sensing means 8 are lower for the sound signal greater than several kilohertz (for example, 3 kHz). The gain will therefore be lowered only slightly by the gain-varying means 5 in the case of "s" and other fricatives or consonants, which are speech signals whose frequency exceeds several kilohertz, making it possible to ensure clearer perception. This result can also be achieved by combining band-pass filters and high-cut filters with the frequency characteristic adding means 7.

It is also possible to adopt an arrangement in which the characteristics of the frequency characteristic adding means 7 are set such that the amplitude decreases with decreasing frequency (in contrast to the case described above), and the characteristics of the gain-varying means 5 are set such the gain increases with an increase in the voltage of the control signal (in contact to the case described above) . This case as well yields characteristics that are close to the frequency characteristics presented by the curves A, B, and C in Fig. 2.

The high frequency range enhancement means 4, the gain-varying means 5 and the amplifier 6 can be configured as an integral unit containing all three devices, or any two of these can be integrated into a single unit. These devices may also be arranged in any sequence.

It is also possible to add any signal processing circuit to the path that extends from the amplifier 1 directly to the addition means 2.

### Second Embodiment

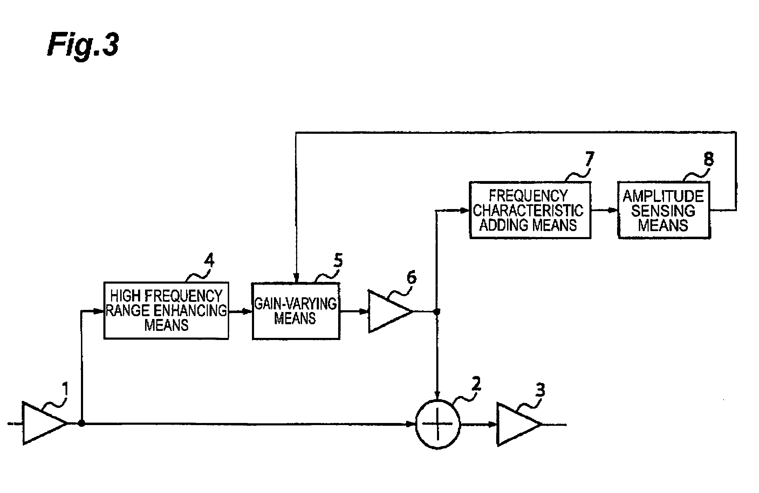

A second embodiment of the present invention will now be described with reference to Fig. 3. Fig. 3 is a block diagram depicting the structure of sound signal processing means according to the second embodiment of the present invention. In the drawing, functional blocks identical to those in Fig. 1 are designated with the same numbers, and their description is omitted herefrom.

This embodiment differs from the first embodiment described above in that the output of the amplifier 6 is input to the frequency characteristic adding means 7.

This construction makes it possible to markedly suppress variations of control signals and to provide accurate control for sound signals with considerable amplitude variations.

### Third Embodiment

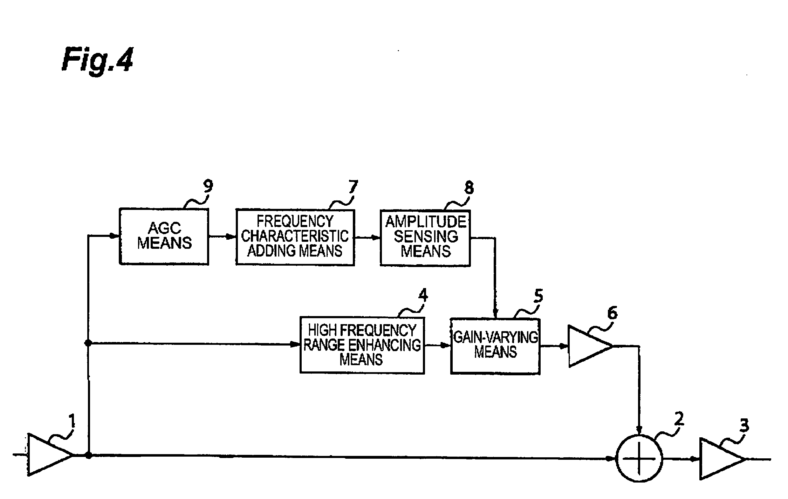

A third embodiment of the present invention will be described with reference to Fig. 4. Fig. 4 is a block diagram depicting the structure of sound signal processing means according to the third embodiment of the present invention. In the drawing, functional blocks identical to those in Fig. 1 are designated with the same numbers, and their description is omitted herefrom.

This embodiment differs from the first embodiment described above in that AGC (Automatic Gain Control) means 9 is provided to the preceding stage of the frequency characteristic adding means 7.

With this structure, an operation is provided in which the AGC means 9 stabilizes the amplitude of a sound signal that is input to the frequency characteristic adding means 7, making it possible to suppress control signal variations and to provide accurate control for sound signals with considerable amplitude variations.

### Fourth Embodiment

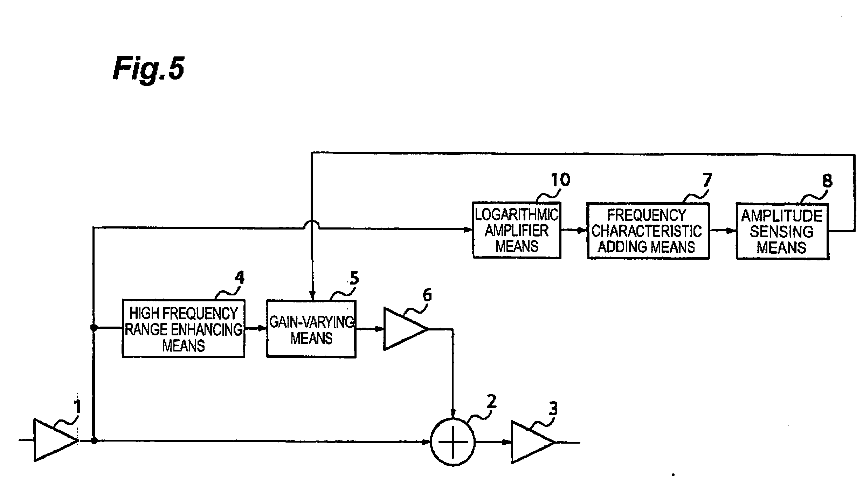

A forth embodiment of the present invention will now be described with reference to Fig. 5. Fig. 5 is a block diagram depicting the structure of sound signal processing means according to the fourth embodiment of the present invention. In the drawing, functional blocks identical to those in Fig. 1 are designated with the same numbers, and their description is omitted herefrom.

This embodiment differs from the first embodiment described above in that logarithmic amplifier means 10 is provided to the preceding stage of the frequency characteristic adding means 7.

With this structure, an operation is provided in which the logarithmic amplifier means 10 reduces the range of amplitude variations affecting a sound signal that is input to the frequency characteristic adding means 7, making it possible to reduce variations in control signals and ensure accurate follow-up control for sound signals with considerable amplitude variations. As a result, more natural sound can be perceived.

As described above, the present invention allows clearly perceived sound to be output by providing processing means having at least high frequency range enhancement processing means and gain-varying means for a sound signal input; addition means for adding the input sound signal and a sound signal obtained through the processing means; and sound signal analysis means for analyzing the input sound signal and generating a control signal for the gain-varying means on the basis of the analysis results.

From the invention thus described, it will be obvious that the embodiments of the invention may be varied in many ways. Such variations are not to be regarded as a departure from the spirit and scope of the invention, and all such modifications as would be obvious to one skilled in the art are intended for inclusion within the scope of the following claims.

## Claims

1. A sound processing apparatus, comprising:
processing means having at least high frequency range enhancement processing means and gain-varying means for a sound signal input;
addition means for adding the input sound signal and a sound signal obtained through the processing means; and
sound signal analysis means for analyzing the input sound signal and generating a control signal for the gain-varying means on the basis of the analysis results.

2. The sound processing apparatus according to claim 1, wherein the sound signal analysis means senses an amplitude of an input sound signal enhanced by frequency characteristic adding means for enhancing an amplitude of said input sound signal within a specified frequency range of said input sound signal, and generates the control signal on the basis of the sensed amplitude.

3. The sound processing apparatus according to claim 2, wherein the frequency characteristic adding means increases the amplitude as the frequency thereof increases within the specified frequency range.

4. The sound processing apparatus according to claim 2, wherein the frequency characteristic adding means increases the amplitude as the frequency thereof decreases within the specified frequency range.

5. The sound processing apparatus according to claim 1 or 2, wherein automatic gain control means for the input sound signal is provided to the preceding stage of the sound signal analysis means.

6. The sound processing apparatus according to claim 1 or 2, wherein logarithmic amplification means for the input sound signal is provided to the preceding stage of the sound signal analysis means.

7. A hearing aid, comprising:
processing means having at least high frequency range enhancement processing means and gain-varying means for a sound signal input;
addition means for adding the input sound signal and the sound signal obtained through the processing means; and
sound signal analysis means for analyzing the input sound signal and generating a control signal for the gain-varying means on the basis of the analysis results.

8. The hearing aid according to claim 7, wherein the sound signal analysis means senses an amplitude of sound signal enhanced by frequency characteristic adding means for enhancing amplitude within a specified frequency range of the input sound signal and generates the control signal on the basis of the sensed amplitude.

9. The hearing aid according to claim 8, wherein the frequency characteristic adding means increases the amplitude as the frequency thereof increases within the specified frequency range.

10. The hearing aid according to claim 8, wherein the frequency characteristic adding means increases the amplitude as the frequency thereof decreases within the specified frequency range.

11. The hearing aid according to claim 7 or 8, wherein automatic gain control means for the input sound signal is provided to the preceding stage of the sound signal analysis means.

12. The hearing aid according to claim 7 or 8, wherein logarithmic amplification means for the input sound signal is provided to the preceding stage of the sound signal analysis means.
